# EUROPÄISCHE PATENTSCHRIFT

(11) **EP 2 834 080 B1**
(45) Veröffentlichungstag und Bekanntmachung des Hinweises auf die Patenterteilung: **29.12.2021**
(21) Anmeldenummer: 13716165.9
(22) Anmeldetag: 02.04.2013
(51) Int. Cl.: B44C 5/04, E06B 3/66, F21V 33/00, F21V 8/00, B32B 17/06, F21Y 115/10

(54) **GLASVERBUND MIT FUNKTIONSELEMENT**
COMPOSITE GLASS WITH FUNCTIONAL ELEMENT
PLAQUE EN VERRE COMPOSITE AVEC UN ÉLÉMENT FONCTIONNEL

(30) Priorität: 02.04.2012 AT 501182012
(43) Veröffentlichungstag der Anmeldung: 11.02.2015
(73) Patentinhaber: IGP Immobilien und Glasproduktionsanlagen GmbH, 1090 Wien (AT)
(72) Erfinder: CZAPKA Linda, 1190 Wien (AT)
(74) Vertreter: Keschmann, Marc
(86) Internationale Anmeldenummer: PCT/AT2013/000054
(87) Internationale Veröffentlichungsnummer: WO 2013/149274

(56) Entgegenhaltungen:
- EP-A1- 0 324 710
- EP-A1- 1 076 205
- EP-A1- 1 346 823
- WO-A1-02/095287
- DE-A1- 10 335 979
- DE-A1-102004 059 742
- DE-A1-102006 027 074
- GB-A- 2 316 216
- None

## Beschreibung

Die Erfindung betrifft einen Glasverbund mit zumindest einer ersten Hauptglastafel, zumindest einer davon beabstandet angeordneten zweiten Hauptglastafel und zumindest einem zwischen den Hauptglastafeln angeordneten Plattenelement.

Zudem betrifft die Erfindung ein Verfahren zur Herstellung eines solchen Glasverbunds.

Ein gattungsgemäßer Glasverbund ist aus der WO 2003/048494 bekannt. Der dort offenbarte Glasverbund ist auf vorteilhafte Weise architektonisch einsetzbar.

Der Erfindung liegt die Aufgabe zu Grunde, den Einsatzbereich des bekannten Glasverbunds über die reine architektonische Verwendung hinaus zu erweitern.

Diese Aufgabe wird zum einen durch einen Glasverbund gemäß Anspruch 1 und zum anderen durch ein Verfahren gemäß Anspruch 11 gelöst.

Bevorzugte und vorteilhafte Ausführungsformen der Erfindung sind Gegenstand der Unteransprüche.

Erfindungsgemäß ist vorgesehen, dass zumindest ein technisches Modul zwischen den beiden Hauptglastafeln angeordnet ist und dass das Plattenelement zumindest teilweise eine an die Form des technischen Moduls angepasste Aussparung begrenzt bzw. definiert, in welcher das technische Modul aufgenommen ist, und dass Beleuchtungsmittel zwischen zwei Hauptglastafeln integriert und zur seitlichen Einspeisung von Licht zwischen die Hauptglastafeln ausgebildet sind und dass die Beleuchtungsmittel mit einem Abstandhalter thermisch gekoppelt sind.

Zudem ist erfindungsgemäß vorgesehen, dass zumindest ein technisches Modul in einer an die Form des technischen Moduls angepassten Aussparung des zumindest einen Plattenelements angeordnet wird und dass das zumindest eine Plattenelement und das zumindest eine technische Modul zwischen den zwei Hauptglastafeln angeordnet werden und dass Beleuchtungsmittel zwischen die Hauptglastafeln integriert werden, die zur seitlichen Einspeisung von Licht zwischen die Hauptglastafeln ausgebildet sind, und dass die Beleuchtungsmittel mit einem Abstandhalter thermisch gekoppelt werden.

Unter einem technischen Modul ist kein Plattenelement im Sinne dieser Patentanmeldung zu verstehen. Es handelt sich also bei diesem Modul um ein von dem Plattenelement unterschiedliches Element.

Durch die erfindungsgemäßen Maßnahmen ist auf vorteilhafter Weise erreicht, dass das technische Modul oder die technischen Module nun staubsicher und kratzfest in dem Glasverbund integriert bzw. aufgenommen sind. Mit einem derart ausgebildeten Glasverbund lassen sich somit nicht nur ästhetisch ansprechende sondern auch funktional Elemente in die Architektur integrieren. Dabei werden herkömmliche metallrahmen, Schrauben, Nieten und dergleichen, die üblicherweise zur Lagestabilisierung oder Positionierung von technischen bzw. elektrischen Modulen benötigt werden und die Ästhetik des Glasverbundes beeinträchtigen würden, vollständig vermieden.

Die zwei Hauptglastafeln können eine vordere und eine hintere Wand des Glasverbundes realisieren. Die Hauptglastafeln können durch alle Glasarten in technischen Aufbauten und Dicken, durch transparente und transluzente Kunststoffe usw. realisiert sein.

Das Plattenelement ist vorzugsweise durchsichtig, insbesondere farblos oder farbig, wobei vorteilhaft das Plattenelement aus z.B. transparentem oder transluzentem Kunststoff, insbesondere aus Acrylglas, gefertigt ist (z.B. PMMA-Polymethylmethacrylat). Als Stoffe für das Plattenelement können jedoch auch Metalle, Mineralien, Holz u.a. zur Anwendung kommen. Das Plattenelement ist üblicherweise parallel zu den Hauptglastafeln ausgerichtet und in etwa gleich groß wie die Hauptglastafeln, insbesondere jedoch um Elemente im Randbereich kleiner ausgebildet als die Hauptglastafeln. Das Plattenelement bzw. die Plattenelemente wirkt (en) als Halterungsscheibe (n) bzw. Rahmen für das Modul. Das einzige Plattenelement ist oder die Plattenelemente sind in einer Ebene zwischen den Hauptglastafeln angeordnet. Diese Ebene kann als Funktionsebene verstanden werden, weil das Modul eine technische Funktion in dem Glasverbund einbringt.

Besonders vorteilhaft ist es daher im Rahmen der Erfindung, wenn das zumindest eine Plattenelement zwischen den beiden Hauptglastafeln in einer Funktionsebene angeordnet ist und als Rahmen innerhalb dieser Funktionsebene für zumindest ein technisches Modul wirkt, indem es eine an die Form des technischen Moduls angepasste Aussparung begrenzt, in welcher das technische Modul aufgenommen ist. Zumindest ein technisches Modul wird also in einer an die Form des technischen Moduls angepassten Aussparung zumindest eines in einer Funktionsebene angeordneten Plattenelements derart angeordnet, dass das zumindest eine Plattenelement als Rahmen für das technische Modul innerhalb dieser Funktionsebene wirkt, und dass das zumindest eine Plattenelement und das zumindest eine technische Modul zwischen den zwei Hauptglastafeln angeordnet werden.

Ein solches Plattenelement kann beispielsweise ein- oder mehrteilig ausgebildet sein. Die gesamte eingenommene Fläche des einen oder mehrteiligen Plattenelements und des Moduls, die ja beide in einer Ebene (Funktionsebene) parallel zu den Hauptglastafeln angeordnet sind, entspricht in etwa der Gesamtfläche des Glasverbunds.

Bei einer einteiligen Ausbildung kann die Aussparung vollständig durch ein Loch in dem Plattenelement definiert sein. Die Aussparung kann jedoch auch am Rand des Plattenelements lokalisiert sein und z.B. zwei oder drei Seiten der Aussparung begrenzen. Die verbleibenden Seiten der Aussparung können durch den Rand des Glasverbunds realisiert sein. Auch bei einer mehrteiligen Ausbildung des Plattenelements können einzelne Plattenelemente nebeneinander in der Ebene zwischen den Hauptglasplatten zumindest bereichsweise bündig aneinander anschließend angeordnet sein. Bei dieser Ausbildung kann die Aussparung in einem der Plattenelemente enthalten sein und das oder die anderen Plattenelemente können frei von Aussparungen sein.

Es können jedoch auch benachbarte Plattenelemente Aussparungen an ihren zueinander hinweisenden Rändern aufweisen, die in Summe die Form der zu definierenden Aussparung für das Modul realisieren. Exakt in diesem Ausschnitt bzw. diese Aussparung im Übergangsbereich zwischen den Plattenelementen ist das Modul eingesetzt. Auch bei einer mehrteiligen Ausbildung befinden sich also sowohl das oder die Plattenelemente als auch das Modul in der Ebene zwischen den Hauptglastafeln (Funktionsebene).

Im montierten Zustand kann sich das Plattenelement sowie das technische Modul von der ersten Hauptglastafel bis zur zweiten Hauptglastafel erstrecken. Es ist auch möglich, dass das Plattenelement nicht nur einen seitlichen Rahmen für das technische Modul bildet sondern, wenn die Tiefe des technischen Moduls geringer ist als der Abstand zwischen den beiden Hauptglastafeln, sich auch über die Vorder- und/oder Rückseite des technischen Moduls erstreckt.

Gemäß einer bevorzugten Ausführungsform ist das Plattenelement mehrteilig, also zumindest zweiteilig ausgebildet. Entlang einer der beiden Plattenelemente oder auch beider Plattenelemente ist die Aussparung ausgebildet, in der das Modul aufgenommen ist. Das Modul ist also in einem Grenzbereich zwischen den zumindest zwei Plattenelementen angeordnet. Es können daher auch benachbart angeordnete Plattenelemente Aussparungen an ihren zueinander benachbarten bzw. zueinander hinweisenden Rändern aufweisen, die in Summe die Form der zu definierenden Aussparung für das Modul realisieren. Die Anzahl der Plattenelemente kann gemäß dem jeweils zu erzielenden optischen Effekten gewählt werden.

Als besonders vorteilhaft hat es sich erwiesen, wenn die Plattenelemente aus glasartigen Tafeln, nachfolgend Rahmenglastafeln genannt, realisiert sind, wobei aus ästhetischer aber auch aus sichtschutztechnischen Gründen die Rahmenglastafeln unterschiedliche Transparenz oder auch unterschiedliche Farben aufweisen. So können z.B. sensorische Funktionen des oder der Module einem weniger transparenten Bereich zugeordnet sein, wohingegen der Visualisierung dienenden Module oder Bereiche solcher Module einem transparenteren Bereich zugeordnet sind.

Bevorzugt ist das Modul ausgewählt aus einer Gruppe der folgenden Elemente: Anzeigeeinheit (z.B. Monitor); Eingabeeinheit, wie Knöpfe oder Tastatur oder dergleichen; Sensoreinheit; Photovoltaikpaneel; strom- und/oder datenführende und/oder datenaufzeichnende Einrichtung, insbesondere Kamera. Mit diesen Elementen lassen sich bereits viele Funktionen eines sogar autonom agierenden Glasverbunds realisieren. Mit Hilfe der Anzeigeeinheit lassen sich Informationen an einen Benutzer oder an einen Passanten kommunizieren. Mit Hilfe der Eingabeeinheit lassen sich Informationen von einer solchen Person zuführen. Eine Sensoreinheit kann z.B. Luftdruck oder -temperatur erfassen, wenn sie über Fühlerelemente mit der Umgebung des Glasverbunds verbunden ist. Die Stromversorgung der einzelnen Elemente kann z.B. mit Hilfe eines integrierten Photovoltaikpaneels Sichergestellt sein, so dass ein autonomer Betrieb möglich ist. Es sei auch erwähnt, dass keine autonome Funktion des Glasverbunds vorliegen muss, wobei in einem solchen Fall die einzelnen Elemente mit der Umgebung des Glasverbunds in Form von drahtloser oder drahtbehafteter Informations- bzw. Energie- bzw. Leistungsübertragung in Verbindung stehen. Das technische Modul kann ein elektronisches oder mechanisches oder z.B. auf physikalischen Prinzipien basierendes Modul, wie z.B. ein Quecksilberthermometer oder ein Barometer oder eine optische Linse, sein.

Gemäß einem weiteren Aspekt sind bei dem Glasverbund zumindest eine der Hauptglastafeln und das Modul mit Hilfe eines Abstandhalters derart in einem Abstand zueinander angeordnet, dass eine Kühlung des Moduls gewährleistet ist. Der Abstandhalter gewährleistet, dass ein zur Kühlung vorgesehener Luftraum zwischen zumindest einer der Hauptglastafeln und dem Modul und/oder dem Plattenelement erhalten bleibt. Dieser Abstand, ist so bemessen, dass er im Betrieb des Moduls eine entsprechend der Kühlung vorgesehene Luftkonvektion erlaubt. Ist der Luftraum nur einseitig ausgebildet, also vor oder hinter dem Modul vorgesehen, so kann er eine Tiefe von 5% bis 90% der Tiefe des Moduls aufweisen. Sind jedoch zwei Lufträume ausgebildet, also einer vor und einer hinter dem Modul, so kann er eine Tiefe von 5% bis 45% der Tiefe des Moduls aufweisen. In beiden Fällen ist sichergestellt, dass das Modul nicht in den Luftraum hineinfällt. Gemäß dieser Ausbildungsform ist der Vorteil erhalten, dass eine zuverlässige Kühlung bzw. Wärmeabfuhr von dem Modul in die Umgebung des Gasverbunds sichergestellt ist.

Gemäß einem weiteren Aspekt der Erfindung weist der Glasverbund Leitungsmittel auf, welche zum elektrisch leitenden Verbinden der elektrischen Anschlüsse des Moduls mit der Umgebung des Glasverbunds vorgesehen sind. Solche Leitungsmittel können in dem Plattenelement eine Bohrung oder Kerbe oder Nut und eine dort aufgenommen elektrische Leitung aufweisen und/oder an Rändern des Plattenelements verlaufende und dort linien- oder flächenartige erste Leitungsbahnen aufweisen und/oder zwischen den Hauptglastafeln randseitig Abstandshalter eingesetzt aufweisen, die den Abstand der Hauptglastafeln zueinander definieren, wobei der Abstandhalter ein Bestandteil der Leitungsmittel ist und bereichsweise elektrisch leitende Strukturen, insbesondere in Form von kabel-, linien- oder flächenartigen zweiten Leitungsbahnen, aufweist, und/oder wobei Eckelemente zwischen den Abstandshaltern einen Bestandteil der Leitungsmittel bilden und eine elektrisch leitende Durchführung aufweisen, um das Modul mit der Umgebung des Glasverbunds elektrisch zu verbinden.

Die Bohrung, Kerbe, Nut oder darin aufgenommene Leitungen können bewusst für gestalterische Zwecke genutzt werden. Um den visuell unbeeinträchtigten Charakter von plan aneinander angeordneten Platten nicht zu beeinträchtigen, können möglichst unauffällige Formen, wie besagte linien- oder flächenartige, erste Leitungsbahnen verwendet werden oder das Material der Plattenelemente kann opak (undurchsichtig) sein. Diese Leitungsbahnen können auch mit Isolationsschichten überzogen sein und entlang der Ränder des Plattenelements nebeneinander oder übereinander geschichtet sein. Im Bereich des aufgenommenen Moduls enden sie dort, wo sie mit elektrischen Kontakten oder elektrischen Leitungen des Moduls kontaktiert sind.

Als Leitungsmittel für die Signalübertragung können jedoch auch Lichtleiter vorgesehen sein, die je nach Anwendungsfall entweder optisch möglichst unauffällig oder einen optischen Akzent gebend in das jeweilige Plattenelement integriert sind oder an dessen Oberfläche verlaufen.

Gemäß einem weiteren Aspekt der Erfindung ist auch der Abstandshalter ein Bestandteil der Leitungsmittel und weist eine bereichsweise elektrisch leitende Struktur, insbesondere in Form von kabel-, linien- oder flächenartigen, zweiten Leitungsbahnen auf. Diese zweiten Leitungsbahnen enden an jenen Bereichen, in denen die ersten Leitungsbahnen des jeweiligen Plattenelements enden. Dort sind die zweiten Leitungsbahnen mit den vorstehend genannten elektrischen Leitern verbunden. Der Abstandshalter kann beispielsweise ein Hohlkörper - z.B. ein Hohlprofilstab - sein und es können Leitungen in ihm aufgenommen sein. Der Abstandshalter kann jedoch auch durch eine Struktur aus stromleitendem Material gebildet sein, wie z.B. in entlang seiner Längserstreckung zwei oder mehrere metallisch leitende Teile getrennt sein, die durch einen isolierenden Teil miteinander verbunden sind, so dass der Abstandshalter selbst eine zwei- oder mehradrige Leitung realisiert. Auch können in dem Abstandhalter zur Signalübertragung Lichtleiter integriert sein, die mit Lichtleitern im jeweiligen Plattenelement gekoppelt sind.

Die entlang der Ränder des Glasverbunds verlaufenden Abstandshalter sind an den Ecken des Glasverbunds durch Eckelemente miteinander verbunden. Auch die Dichtheit des Glasverbunds bleibt durch das Eckelement gewährleistet, weil nicht das Dichtungsmaterial und andere Materialien des Glasverbunds durchbrochen werden müssen. Demgemäß sind diese Eckelemente zwischen den Abstandshaltern ebenfalls ein Bestandteil der Leitungsmittel und weisen eine elektrisch leitende Durchführung auf, um das Modul mit der Umgebung des Glasverbunds elektrisch zu verbinden, ohne die Dichtheit des Glasverbunds zu gefährden. Die elektrisch leitende Durchführung kann mit Hilfe eines Kabels realisiert sein. Das Kabel kann außerhalb des Glasverbunds in beliebigen Steckern enden.

Bevorzugt ist die elektrisch leitende Durchführung durch einen im Eckelement integrierten Stecker realisiert, der mittels eines Kabels eine Stromeinführung von außen erlaubt und so die innerhalb des Abstandhalters liegenden stromverbrauchenden Elemente verbindet und ihren Stromanschluss realisiert.

Gemäß einem bevorzugten Ausführungsbeispiel besteht der Glasverbund aus lediglich zwei Hauptglastafeln und zwischen diesen Hauptglastafeln erstreckt sich eine einzige Funktionsebene. In dieser Ausbildung können Beleuchtungsmittel zwischen den zwei Hauptglastafeln integriert und zur seitlichen Einspeisung von Licht zwischen die Hauptglastafeln in einen Plattenrand des Plattenelements vorgesehen sein. Besagte Beleuchtungsmittel können sogenannte Leuchtstofflampen oder auch Energiesparlampen aufweisen. Gemäß einer bevorzugten Ausbildungsform weisen die Beleuchtungsmittel eine oder mehrere Leuchtdioden, insbesondere in Form einer Leuchtdiodenleiste auf. Besagte Leuchtmittel sind randseitig an dem Glasverbund zwischen den Hauptglastafeln angeordnet und strahlen Licht in die Bereiche zwischen den Hauptglastafeln ein. Das Licht wird also seitlich (randseitig) eingestrahlt und tritt flächig über die Oberflächen (Front und/oder Rückfläche) der Plattenelemente wieder aus. In einem derart ausgeleuchteten Plattenelement wird das oder die Module mit diesem Licht beleuchtet. Zugleich kann dieses Licht zur Raumbeleuchtung für die Umgebung des Glasverbunds benutzt werden.

Gemäß einer weiteren Ausbildungsform kann der Glasverbund benachbart zu einer der Hauptglastafeln, insbesondere jener Hauptglastafel, die einer Rückseite des Moduls zugewandt ist, eine Beleuchtungslage aufweisen, die in einer Ebene parallel zu besagter Hauptglastafel verläuft und zwischen besagter Hauptglastafel und einer dritten Hauptglastafel eine eingebettete lichtleitende Beleuchtungstafel aufweist. Dies bringt den Vorteil mit sich, dass die jeweilige Beleuchtungsglastafel vollständig ausgeleuchtet werden kann. Für den Fall, dass die Beleuchtungsglastafeln in Blickrichtung vor dem Modul angeordnet ist, erscheint das gesamte Modul in der jeweils gewählten Farbe des Lichtes. Die Farbe kann jedoch auch durch die Farbe der Beleuchtungsglastafel gewählt werden. Für den Fall, dass die Beleuchtungsglastafel hinter dem Modul angeordnet ist, also das Modul in Blickrichtung vor der Beleuchtungsglastafel gelagert ist, erscheint das Modul aus dem Hintergrund her angeleuchtet. Die Beleuchtungsglastafel kann sowohl den Bereich vor dem Glasverbund als auch den Bereich hinter dem Glasverbund mit einem Licht derselben Farbe beleuchten.

Gemäß einem weiteren Aspekt der Erfindung weist der Glasverbund benachbart zu einer der Hauptglastafeln, insbesondere jener Hauptglastafel, die einer Rückseite des Moduls zugewandt ist, eine Farblage auf, die in einer Ebene parallel zu besagter Hauptglastafel verläuft und zwischen besagter Hauptglastafel und einer weiteren Hauptglastafel eingebettet eine Farbtafel aufweist. Die zusätzliche Farbtafel erlaubt die Bereitstellung zusätzlicher optischer Funktionen, wie z.B. Sichtschutz von z.B. hinten, um das Modul oder andere Elemente des Glasverbunds optisch zu verbergen; Sonnenschutz; wenn die Farbebene von innerhalb des Glasverbunds her beleuchtet wird, können mit Ihr auch Farbeffekte erzielt werden, wie beispielsweise hinter dem Glasverbund eine andere Lichtfarbe als vor dem Glasverbund. Der Glasverbund weist folglich eine zu der Halterungsscheibe (Hauptglastafel) angeordnete Leuchtscheibe (Beleuchtungstafel) auf, wobei die Leuchtscheibe aus lichtleitendem Material gebildet ist. Die Halterungsscheibe ist durch Lichteinspeisungen an mindestens einer randseitigen Seitenkante der Leuchtscheibe und Lichtaustritt über ihre der Halterungsscheibe zugewandten Fläche flächig beleuchtbar, wobei zwischen der Halterungsscheibe und der Leuchtscheibe ein Abstandsmaterial flächig vorgesehen ist, das einen von dem Brechungsindex der Farbscheibe (Farbtafel) abweichenden Brechungsindex aufweist. Durch die so erzielte Beleuchtbarkeit können die technischen Elemente bzw. Module in verschiedenen Anwendungen die zuvor beschriebenen optischen und I oder visuelle Funktionen einnehmen bzw. entfalten. Die Leuchtscheibe bildet darüber einen Beleuchtungskörper, der ein Umgebungslicht herstellt, das über den Glasverbund hinausstrahlt, sozusagen die Umgebung des Glasverbunds beleuchtet.

Gemäß einem weiteren Aspekt der Erfindung sind die Leuchtdioden, bevorzugt die Leuchtdiodenleiste an dem rechten und/oder linken und/oder oberen Rand des Glasverbunds angeordnet. Es lassen sich somit richtungsabhängige Lichteindrücke oder eine homogene Ausleuchtung, also eine richtungsunabhängige Ausleuchtung erzielen. Die einzelnen Leuchtdiodenleisten lassen sich auch zu verschiedenen Zeitpunkten mit Strom versorgen und können so lichtdynamische Effekte erzielen.

Gemäß der Erfindung sind die Beleuchtungsmittel thermisch gekoppelt mit dem Abstandhalter. Die Beleuchtungsmittel sind in Bezug auf den äußeren Rand des Glasverbunds innerhalb des Abstandshalters angeordnet und produzieren dort Wärme. Die thermische Kopplung ist insbesondere dann von Vorteil, wenn die Abstandhalter aus einem thermisch gut leitfähigem Material, insbesondere einem Metall (z.B. Aluminium) oder einer Legierung bestehen. Die thermische Kopplung aus Beleuchtungsmittel und Abstandhalter realisiert einen Kühlkörper, mit dessen Hilfe die durch die Beleuchtungsmittel erzeugte Wärme effizient aus dem Glasverbund heraus transportiert werden kann. Die thermische Kopplung kann durch engen Kontakt der Teile miteinander, wie z.B. miteinander Verkleben oder mit Hilfe einer Wärmeleitpaste usw. erfolgen.

Für den Fall, dass die Beleuchtungsmittel in derselben Ebene wie das Modul angeordnet sind kann besagter Kühlkörper auch zur Abfuhr von Wärme genutzt werden, die durch den Betrieb des Moduls in dem Glasverbund erzeugt wird.

Als besonders vorteilhaft hat es sich erwiesen, wenn der Abstandshalter in Form eines Hohlprofils realisiert ist, so dass eine möglichst große Oberfläche zur Kühlung bereit steht.

Gemäß einem bevorzugten Ausführungsbeispiel weisen die Beleuchtungsmittel eine Leuchtdiodenleiste aufweisend eine Platine mit daran befestigten Leuchtdioden auf. Die Platine dient als Kühlkörper zur Wärmeabfuhr.

Ein solcher Glasverbund lässt sich wie folgt herstellen. Zunächst werden die Hauptglastafeln gefertigt und bereitgestellt und mit entsprechenden Positionierungs- und Begrenzungssteilen (Abstandshalter, Eckelemente, elastisches Randelement) eingerahmt. Die hintere Hauptglastafel wird flach aufgelegt. Auf dieser Hauptglastafel werden das jeweilige Plattenelement und das in die Aussparung eingesetzte Modul aufgelegt und das Modul an die elektrischen Leitungen (z.B. Stromversorgungsleitungen) angeschlossen. Danach wird die vordere Hauptglastafel auf die Primärdichtung aufgelegt. Demgemäß erfolgt ein Anordnen von zumindest einem glasartigen Plattenelement zwischen zwei Hauptglastafeln, wobei das zumindest eine Plattenelement eine an die Größe des Moduls angepasste Aussparung definiert, und eine Anordnen von besagtem Modul in besagter Aussparung. Wie eingangs bereits erwähnt, kann das Plattenelement auch mehrteilig ausgebildet sein. In diesem Fall kann das Modul in die durch zwei oder mehrere Plattenelemente begrenzte Aussparung eingesetzt werden.

Optional können auch Beleuchtungsmittel in den Glasverbund aufgenommen werden, die zwischen Hauptglastafeln integriert werden und die zur seitlichen Einspeisung von Licht zwischen die Hauptglastafeln ausgebildet sind. Die Integration der Beleuchtungsmittel kann in der Ebene des Moduls oder in einer dazu benachbarten Ebene erfolgen. Die Beleuchtungsmittel werden mit dem in Bezug auf das Zentrum des Glasverbunds weiter außen lokalisierten Abstandhalter zur Erzielung vorstehend genannter Effekte wie erwähnt thermisch gekoppelt.

Der zusammengefügte Glasverbund kann nun aufgestellt werden und das elektrische Modul in Betrieb genommen werden. Jene Elemente, welche das oder die Plattenelemente zusammen mit dem Modul rahmenartig umfassen, dienen im Wesentlichen drei Funktionen, nämlich Abstandshaltung und elastisches Abstützen, Definieren eines Abstands des Plattenelements von den Rändern des Glasverbunds, und Dichtheit des Glasverbunds. Dies schützt das elektrische Modul vor Feuchtigkeit und sonstigen Umwelteinflüssen.

Zusammengefasst offenbart die Erfindung ein technisches Verfahren, durch das technische Module wie Monitore, Anzeigen, Sensoren ins Glas eingesetzt werden können und zugleich deren Beleuchtung und die der Glasfläche gewährleistet werden. Dazu werden erfindungsgemäß in einen Glasverbund plattenförmige, zum Beispiel Acrylglaselemente gestellt, deren Auslassungen gemäß des Bedarfs der verschiedenen technischen Teile (Module) und deren Verkabelung aufnehmen können und zugleich eine Halterung für diese technischen Teile bilden. Durch die Integration von Leuchtmitteln können diese im Glasverbund aufgenommenen Plattenelemente und deren integrierten Module beleuchtet werden. Die so in den Glasverbund integrierten technischen Module erwecken den Anschein als würden sie ohne irgendwelche Montagehalterungen gehalten einfach nur im Glas schweben. Die Position, Lage und Orientierung der Module lässt sich durch die präzise Bearbeitbarkeit der Plattenelemente bzw. des Plattenelements sehr genau definieren. Der zu erwartenden Wärmeentwicklung im Betrieb wird durch einen entsprechenden Abstand zu den Glasplatten Rechnung getragen. Außerdem wird die Wärmeableitung von den Leuchtmitteln, wie zum Beispiel den Leuchtdioden, durch speziell beschaffene Platine (Printplatte) über den Abstandshalter, der mit der Platine thermisch gekoppelt ist, aus dem Inneren des Glasverbunds nach außen geleitet.

Die spezielle Anordnung der Module in der Aussparung des Plattenelements ermöglicht eine passgenaue Aufnahme der technischen Module und fixiert diese auf zuverlässige Art und Weise. Hinsichtlich der Strom- und Datenübertragungskabel sei erwähnt, dass diese nicht nur über konventionelle Kabel, sondern durch speziell gestaltete beinahe unsichtbare Leitungen bzw. Materialien optisch kaum wahrnehmbar in dem Glasverbund integriert werden können.

Merkmale des Verfahrens können entsprechend den Merkmalen der Vorrichtung weiter gebildet sein. Die im Zusammenhang mit der Vorrichtung genannten Vorteile gelten übertragen auch für das verfahren.

Weitere Einzelheiten, Merkmale und Vorteile der Erfindung ergeben sich aus der nachstehenden Beschreibung unter Bezugnahme auf die angeschlossenen Zeichnungen, in welchen bevorzugte Ausführungsformen dargestellt sind.

Es zeigt:
Fig. 1 ein Glasverbund gemäß einem ersten Ausführungsbeispiel der Erfindung;
Fig. 2 eine Schnittdarstellung durch den Glasverbund gemäß der Figur 1;
Fig. 3 ein Modul und zwei für die Aufnahme des Moduls vorgesehene Rahmenglastafeln losgelöst voneinander;
Fig. 4 die Elemente gemäß der Figur 3 in zusammengebautem Zustand;
Fig. 5 Leitungsmittel gemäß einem ersten Ausführungsbeispiel;
Fig. 6 Leitungsmittel gemäß einem zweiten Ausführungsbeispiel;
Fig. 7 ein Detail des Glasverbunds gemäß der Figur 1 mit Beleuchtungsmitteln;
Fig. 8 - 9 weitere Ausführungsbeispiele der Erfindung.

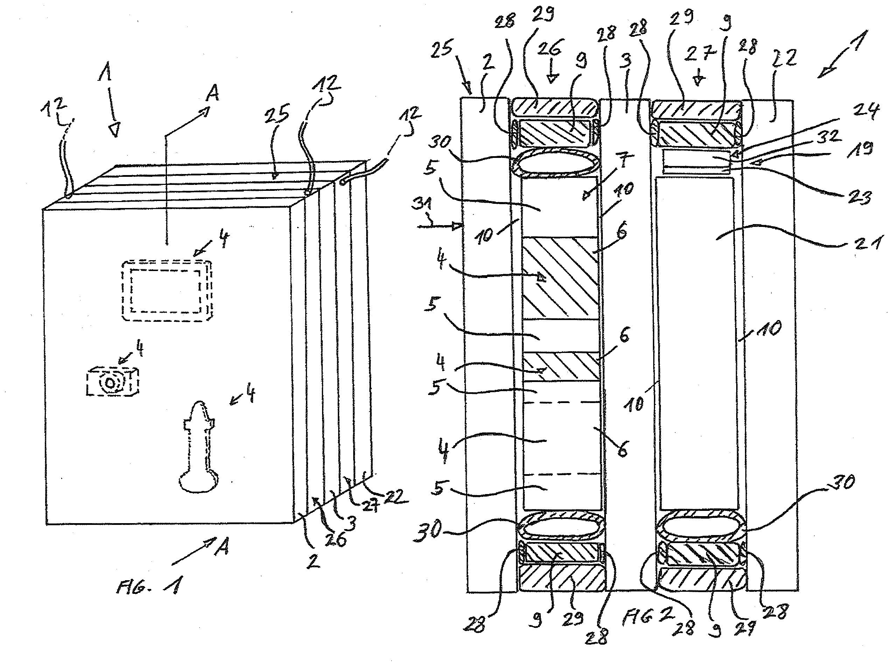

In der Figur 1 ist ein Glasverbund 1 dargestellt, der eine erste Hauptglastafel 2 als Frontscheibe und eine zweite Hauptglastafel 3 als Zentralscheibe aufweist. Zwischen der ersten und der zweiten Hauptglastafel 2, 3 ist eine Funktionsebene bzw. Modullage 26 angeordnet. In dieser Modullage 26 sind vier verschiedene Module 4 integriert, wie zum Beispiel das oberste als Anzeigeeinheit, die zwei mittleren als Eingabeeinheit und das rechts unten lokalisierte als Sensoreinheit. Hinter der zweiten Hauptglastafel 3 ist eine Beleuchtungslage 27 und eine parallel dazu anschließende dritte Hauptglastafel 22 als Rückwand vorgesehen. Die Beleuchtungslage 27 dient der rückwärtigen Beleuchtung der Modullage 26 bzw. der darin aufgenommenen Module 4. Die Modullage 26 als auch die Beleuchtungslage 27 sind im Bereich ihrer Ecken mit elektrischen Anschlüssen 12 versehen, die im vorliegenden Fall als Kabel ausgebildet sind.

In der Figur 2 ist eine Schnittdarstellung entlang der in der Figur 1 dargestellten Schnittebene A-A zu sehen, in der weitere Details des Glasverbunds 1 sichtbar sind. Ein Pfeil 31 zeigt eine Betrachtungsrichtung auf den Glasverbund 1 an. Zwischen den drei Hauptglastafeln 2, 3, 22 sind in der Schnittebene A-A zumindest zwei obere Module 4 in ihrem Querschnitt zu sehen. Deutlich zu sehen ist auch, dass das Plattenelement 5 eine an die Form des jeweiligen Moduls 4 angepasste Aussparung 6 aufweist, in welcher das Modul' 4 aufgenommen ist.

Im vorliegenden Fall ist das Plattenelement 5 durch eine einzige Rahmenglastafel 7 gebildet, die entsprechend der Anzahl der Module 4 angepasste Aussparungen 6 aufweist. Zwischen den Hauptglastafeln 2, 3, 22 sind randseitig Abstandshalter 9 eingesetzt, die den Abstand der Hauptglastafeln 2, 3, 22 zueinander derart definieren, dass sich ein Spalt 10 zwischen den Hauptglastafeln 2, 3, 22 und dem Modul 4 sowie dem Plattenelement 5 ausbildet, so dass die in dem Modul 4 zu erwartende Wärmeentwicklung über die Luft zwischen dem Modul 4 und dem Plattenelement 5 einerseits und der jeweiligen Hauptglastafel 2, 3, 22 andererseits abgeführt werden kann. Der Abstandshalter 9 ist seinerseits in eine Primärdichtung 28 in Richtung der Hauptglastafeln 2, 3, 22 eingebettet. Außerhalb des Abstandshalters 9 befindet sich eine Sekundärdichtung 29, die an ihrer Außenseite bündig mit dem äußeren Rand der Hauptglastafeln 2, 3, 22 abschließt. Innerhalb des Abstandshalters 9 ist zumindest in der Funktionsebene der Module 4, also der Modullage 26 ein das Plattenelement 5 im Wesentlichen vollständig umfangsseitig umschließendes elastisches Randelement 30 in Form eines Silikonschlauchs vorgesehen.

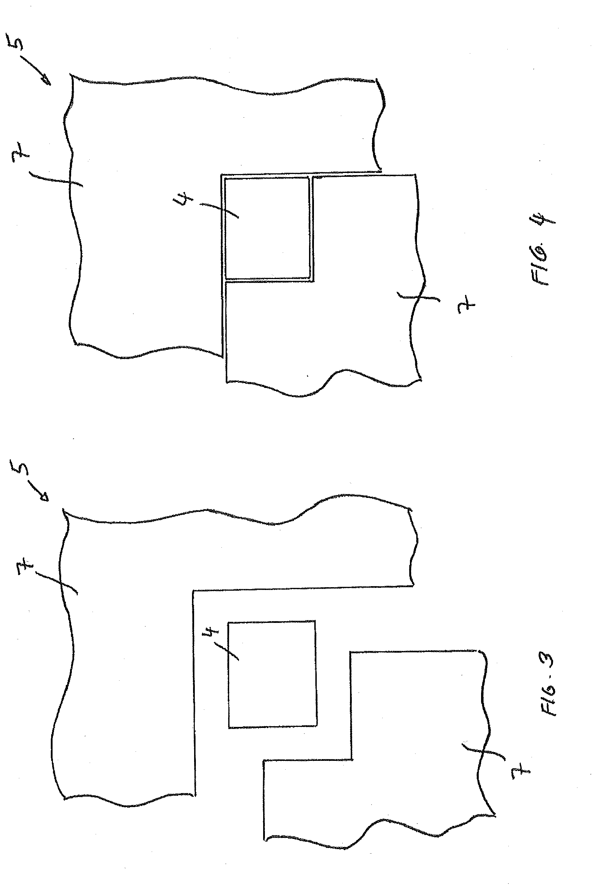

Auch in der Beleuchtungslage 27 ist besagter Abstandshalter 9 eingebettet in besagte Primärdichtung 28 vorhanden. Ebenso befindet sich außerhalb des Abstandshalters 9 besagte Sekundärdichtung 29. Im Unterschied zu der Modullage 26, bei der das elastische Randelement 30 den gesamten Umfang umschließt, ist in der Beleuchtungslage 27 das elastische Randelement 30 nur am linken, rechten und unteren Rand ausgebildet. Am oberen Rand ist zwischen einer Beleuchtungstafel bzw. Beleuchtungsglastafel 21 und dem oberen Abstandshalter 9 eine Leuchtdiodenleiste 24 aufweisend eine Anzahl von Leuchtdioden 23 angeordnet. Die Beleuchtungstafel 21 realisiert zusammen mit der Leuchtdiodenleiste 24 Bestandteile von Beleuchtungsmittel 19, die zur Beleuchtung der Modullage 26 bzw. der in der Modullage 26 aufgenommenen Module 4 dienen. Im vorliegenden Fall sind die Beleuchtungsmittel 19 zwischen der zweiten Hauptglastafel 3 und der dritten Hauptglastafel 22 eingebettet. Die Leuchtdioden 23 der Leuchtdiodenleiste 24 sind randseitig an dem Glasverbund 1 zwischen der zweiten Hauptglastafel 3 und der dritten Hauptglastafel 22 angeordnet und strahlen Licht in die Bereiche zwischen den Hauptglastafeln 3 und 22, das sich entlang der Beleuchtungstafel 21 ausbreitet. Das Licht tritt aus der Beleuchtungstafel 21 über ihre den Modulen 4 zugewandte Frontseite aus und beleuchtet so die Module 4 von hinten und schimmert zwischen ihnen hindurch. Das Licht tritt aus der Beleuchtungsscheibe 21 über ihre zu besagter Frontseite parallel orientierte Rückseite aus und beleuchtet dort den hinter dem Glasverbund 1 befindlichen Raum. In der Figur 3 ist ein Plattenelement 5 gemäß einem weiteren Ausführungsbeispiel der Erfindung dargestellt. Dieses Plattenelement 5 weist zwei Rahmenglastafeln 7 auf. Im vorliegenden Fall weist die linke untere Rahmenglastafel 7 eine Aussparung in einer Form auf, die es gestattet, das Modul 4 vollständig an seinem linken und unteren Rand aufzunehmen bzw. zu umschließen. Im zusammengesetzten Zustand sind die drei Elemente, nämlich die beiden Rahmenglastafeln 7 und das Modul 4 so wie in der Figur 4 dargestellt angeordnet. Aus Gründen der

Übersichtlichkeit sind in der Figur 4 Zwischenräume zwischen den Elementen 5 und 7 dargestellt, die in der Realität wegen der passgenauen Anpassung der Aussparungen der einzelnen Rahmenglastafeln 7 an die Kontur des Moduls 4 nicht in diesem Ausmaß oder gar nicht auftreten. Für einen Betrachter einer realen Ausbildung erscheint es so, als würden die Elemente nahtlos ineinander übergehen.

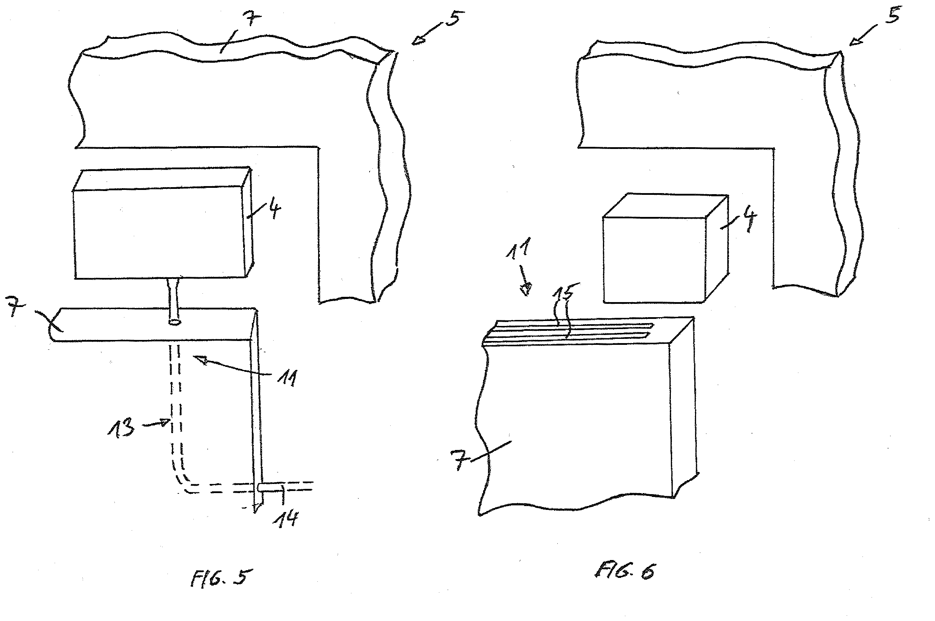

In der Figur 5 ist eine zu der Figur 3 ähnliche Konfiguration im Schrägriss dargestellt. Im vorliegenden Fall ist der Fokus auf Leitungsmittel 11 gerichtet, die in der unteren links angeordneten Rahmenglastafel 7 in Form einer Bohrung 13 mit einer darin aufgenommenen elektrische Leitung 14 ausgebildet sind, wobei die Leitung 14 mit dem Modul 4 elektrisch leitend verbunden ist. Die elektrische Leitung 14 ist mit dem Modul 4 fix oder mit Hilfe von nicht dargestellten Steckverbindungen trennbar verbunden.

In der Figur 6 ist ein weiteres Ausführungsbeispiel zu den Leitungsmitteln 11 offenbart, die im vorliegenden Fall an Rändern der links unten angeordneten Rahmenglastafel 7 in Form von linien- oder flächenartigen ersten Leiterbahnen 15 ausgebildet sind. Die Leitungsmittel 11 werden durch Aufsetzen des Moduls 4 kontaktiert.

Nicht im Detail dargestellt ist der Umstand, dass der Abstandshalter ein Bestandteil der Leitungsmittel 11 ist und bereichsweise elektrisch leitende Strukturen aufweist, insbesondere in Form von kabel-, linien- oder flächenartigen zweiten Leitungsbahnen 16, die mit den ersten Leitungsbahnen 15 elektrisch leitend verbunden sind.

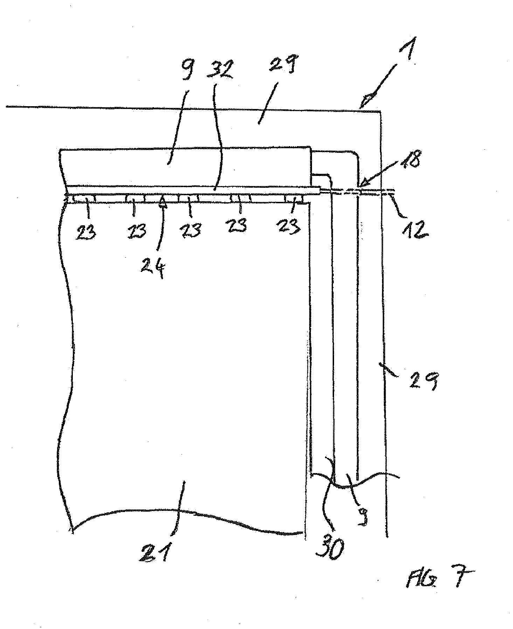

Die Figur 7 zeigt ein Detail des rechts oben lokalisierten Bereichs der Beleuchtungslage 27. Dort sind Beleuchtungsmittel 19 visualisiert , die durch eine Leuchtdiodenleiste 24 aufweisend eine Anzahl von Leuchtdioden 23 befestigt an einer Platine 32 realisiert sind. Die Platine 32 ist thermisch mit dem Abstandselement 9 gekoppelt. Zwischen benachbarten Abstandshalter 9 ist ein diese verbindendes Eckelement 17 dargestellt. Das Eckelement 17 weist eine Durchführung 18 auf, in die ein Kabel als elektrischer Anschluss 12 eingesetzt ist, mit dem die Leuchtdiodenleiste 24 mit der Umgebung des Glasverbunds 1 verbunden ist.

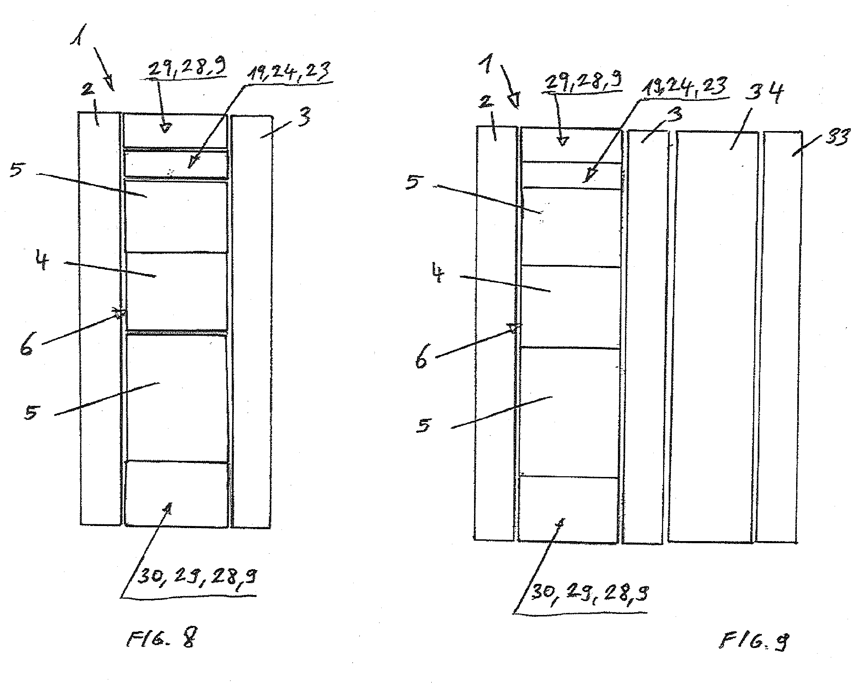

In der Figur 8 ist ein Glasverbund 1 mit einer einzigen Ebene zwischen den Hauptglastafeln 2 und 3 dargestellt, wobei hier auch die Beleuchtungsfunktion im oberen Teil integriert ist.

In der Figur 9 ist in Richtung der Rückseite des Moduls 4 eine vierte Hauptglastafel 33 und wischen den Hauptglastafeln 3 und 33 eine Farbtafel 34 integriert. Mit ihrer Hilfe erscheint die Rückseite des Glasverbunds 1 in einer anderen Lichtfarbe als es die Vorderseite.

Es wird abschließend noch einmal darauf hingewiesen, dass es sich bei den vorangehend detailliert beschriebenen Figuren nur um Ausführungsbeispiele handelt, welche vom Fachmann in verschiedenster Weise modifiziert werden kann, ohne den Bereich der Erfindung zu verlassen. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können.

### BEZUGSZEICHENLISTE

- 1: Glasverbund
- 2: erste Hauptglastafel
- 3: zweite Hauptglastafel
- 4: Modul
- 5: Plattenelement
- 6: Aussparung
- 7: Rahmenglastafel
- 8: nicht benützt
- 9: Abstandshalter
- 10: Spalt (Abstand)
- 11: Leitungsmittel
- 12: elektrische Anschlüsse
- 13: Bohrung, Kerbe, Nut, usw. (Betrachtungsrichtung)
- 14: Leitung
- 15: erste Leitungsbahnen
- 16: zweite Leitungsbahnen
- 17: Eckelemente
- 18: Durchführung
- 19: Beleuchtungsmittel
- 20: nicht benützt
- 21: Beleuchtungstafel
- 22: dritte Hauptglastafel
- 23: Leuchtdiode
- 24: Leuchtdiodenleiste
- 25: nicht benützt
- 26: Modullage
- 27: Beleuchtungslage
- 28: Primärdichtung
- 29: Sekundärdichtung
- 30: elastisches Randelement
- 31: Pfeil
- 32: Platine
- 33: (weitere) vierte Hauptglastafel
- 34: Farbtafel

## Patentansprüche

1. Glasverbund mit zumindest einer ersten Hauptglastafel (2), zumindest einer davon beabstandet angeordneten zweiten Hauptglastafel (3) und zumindest einem zwischen den Hauptglastafeln (2, 3) angeordneten Plattenelement (5), wobei zumindest ein technisches Modul (4) zwischen den beiden Hauptglastafeln (2, 3) angeordnet ist und wobei das Plattenelement (5) eine an die Form des technischen Moduls (4) angepasste Aussparung (6) begrenzt, in welcher das technische Modul (4) aufgenommen ist, **dadurch gekennzeichnet, dass** Beleuchtungsmittel (19) zwischen zwei Hauptglastafeln (2, 3, 22, 33) integriert und zur seitlichen Einspeisung von Licht zwischen die Hauptglastafeln (2, 3, 22, 33) ausgebildet sind und dass die Beleuchtungsmittel (19) mit einem Abstandhalter (9) thermisch gekoppelt sind.

2. Glasverbund nach Anspruch 1, **dadurch gekennzeichnet, dass** das Plattenelement (5) zumindest zweiteilig ausgebildet ist und dass die zumindest zwei Teile in der Ebene zwischen den Hauptglastafeln (2, 3) an Ränder des technischen Moduls (4) angrenzen.

3. Glasverbund nach Anspruch 1 oder 2, **dadurch gekennzeichnet, dass** das technische Modul (4) eine Anzeigeeinheit, eine Eingabeeinheit, eine Sensoreinheit, ein Photovoltaikpaneel oder eine ström- und/oder datenführende und/oder datenaufzeichnende Einrichtung, insbesondere eine Kamera, ist.

4. Glasverbund nach einem der Ansprüche 1 bis 3, **dadurch gekennzeichnet, dass** zumindest eine der Hauptglastafeln (2, 3) und das technische Modul (4) mit Hilfe eines Abstandshalters (9) derart in einem Abstand zueinander angeordnet sind, dass eine Kühlung des technischen Moduls (4) gewährleistet ist.

5. Glasverbund nach einem der Ansprüche 1 bis 4, **dadurch gekennzeichnet, dass** benachbart zu einer der Hauptglastafeln (2, 3), insbesondere jener Hauptglastafel (3), die einer Rückseite des technischen Moduls (4) zugewandt ist, eine Beleuchtungsanlage vorgesehen ist, die in einer Ebene parallel zu dieser Hauptglastafel (2, 3) verläuft und zwischen dieser Hauptglastafel (2, 3) und einer dritten Hauptglastafel (22) eine eingebettete, lichtleitende Beleuchtungstafel (21) aufweist.

6. Glasverbund nach einem der Ansprüche 1 bis 5, **dadurch gekennzeichnet, dass** benachbart zu einer der Hauptglastafeln (2, 3, 22), insbesondere jener Hauptglastafel (3, 22), die einer Rückseite des technischen Moduls (4) zugewandt ist, eine Farblage vorgesehen ist, die in einer Ebene parallel zu dieser Hauptglastafel (2, 3, 22) verläuft und zwischen dieser Hauptglastafel (2, 3, 22) und einer weiteren Hauptglastafel (33) eingebettet eine Farbtafel (34) aufweist.

7. Glasverbund nach einem der Ansprüche 1 bis 6, **dadurch gekennzeichnet, dass** Leitungsmittel (11) vorgesehen sind, welche zum elektrisch leitenden Verbinden der elektrischen Anschlüsse (12) des technischen Moduls (4) mit der Umgebung des Glasverbunds (1) vorgesehen sind,
- wobei die Leitungsmittel (11) in dem Plattenelement (5) eine Bohrung oder Kerbe oder Nut (13) und eine dort aufgenommene elektrische Leitung (14) aufweisen und/oder
- wobei die Leitungsmittel (11) an den Rändern des Plattenelements (5) verlaufende und dort linien- oder flächenartige, erste Leitungsbahnen (15) aufweisen und/oder
- wobei zwischen den Hauptglastafeln (2, 3) randseitig Abstandhalter (9) eingesetzt sind, die den Abstand der Hauptglastafeln (2, 3) zueinander definieren, wobei der Abstandhalter (9) ein Bestandteil der Leitungsmittel (11) ist und bereichsweise elektrisch leitende Strukturen, insbesondere in Form von kabel-, linien- oder flächenartigen, zweiten Leitungsbahnen (16), aufweist und/oder wobei Eckelemente (17) zwischen den Abstandhaltern (9) einen Bestandteil der Leitungsmittel (11) bilden und eine elektrisch leitende Durchführung (18) aufweisen, um das technische Modul (4) mit der Umgebung des Glasverbunds (1) elektrisch zu verbinden.

8. Glasverbund nach einem der Ansprüche 1 bis 7, **dadurch gekennzeichnet, dass** die Beleuchtungsmittel (19) eine Leuchtdiodenleiste (24) aufweisend eine Platine (32) mit daran befestigten Leuchtdioden (23) aufweisen und dass die Platine (32) als Kühlkörper dient.

9. Glasverbund nach einem der Ansprüche 1 bis 8, **dadurch gekennzeichnet, dass** das zumindest eine Plattenelement (5) zwischen den beiden Hauptglastafeln (2, 3) in einer Funktionsebene angeordnet ist und als Rahmen in dieser Funktionsebene für zumindest ein technisches Modul (4) wirkt, indem es eine an die Form des technischen Moduls (4) angepasste Aussparung (6) begrenzt, in welcher das technische Modul (4) aufgenommen ist.

10. Verfahren zum Herstellen eines Glasverbunds (1) mit zumindest einer ersten Hauptglastafel (2), zumindest einer davon beabstandet angeordneten zweiten Hauptglastafel (3) und zumindest einem zwischen den Hauptglastafeln (2, 3) angeordneten Plattenelement (5), wobei zumindest ein technisches Modul (4) in einer an die Form des technischen Moduls (4) angepassten Aussparung (6) des zumindest einen Plattenelements (5) angeordnet wird und dass das zumindest eine Plattenelement (5) und das zumindest eine technische Modul (4) zwischen den zwei Hauptglastafeln angeordnet werden, **dadurch gekennzeichnet, dass** Beleuchtungsmittel (19) zwischen die Hauptglastafeln (2, 3, 22, 33) integriert werden, die zur seitlichen Einspeisung von Licht zwischen die Hauptglastafeln (2, 3, 22, 33) ausgebildet sind, und dass die Beleuchtungsmittel (19) mit einem Abstandhalter (9) thermisch gekoppelt werden.

11. Verfahren nach Anspruch 10, **dadurch gekennzeichnet, dass** das Plattenelement (5) zumindest zweiteilig ausgebildet ist und die Teile des Plattenelements (5) beim Anordnen derart ausgerichtet werden, dass in der Ebene zwischen den Hauptglastafeln (2, 3) Ränder des technischen Moduls (4) an die Plattenränder der Teile des Plattenelements (5) angrenzen.

12. Verfahren nach Anspruch 10 oder 11, **dadurch gekennzeichnet, dass** zwischen Hauptglastafeln (2, 3) randseitig Abstandhalter (9) eingesetzt werden, so dass zumindest eine der Hauptglastafeln (2, 3) und das technische Modul (4) mit Hilfe der Abstandshalter (9) derart in einem Abstand zueinander angeordnet sind, dass eine Kühlung des technischen Moduls (4) gewährleistet ist.

13. Verfahren nach einem der Ansprüche 10 bis 12, **dadurch gekennzeichnet, dass** benachbart zu einer der Hauptglastafeln (2, 3), insbesondere jener Hauptglastafel (3), die einer Rückseite des technischen Moduls (4) zugewandt ist, eine Beleuchtungsanlage angeordnet wird, die in einer Ebene parallel zu dieser Hauptglastafel (2, 3) verläuft und zwischen dieser Hauptglastafel (2, 3) und einer dritten Hauptglastafel (22) eine eingebettete, lichtleitende Beleuchtungstafel (21) aufweist und/oder dass benachbart zu einer der Hauptglastafeln (2, 3, 22), insbesondere jener Hauptglastafel (3, 22), die einer Rückseite des technischen Moduls (4) zugewandt ist, eine Farblage angeordnet wird, die in einer Ebene parallel zu dieser Hauptglastafel (2, 3, 22) verläuft und zwischen dieser Hauptglastafel (2, 3, 22) und einer weiteren Hauptglastafel (33) eingebettet eine Farbtafel (34) aufweist.

14. Verfahren nach einem der Ansprüche 10 bis 13, **dadurch gekennzeichnet, dass** zumindest ein technisches Modul (4) in einer an die Form des technischen Moduls (4) angepassten Aussparung (6) zumindest eines in einer Funktionsebene angeordneten Plattenelements (5) derart angeordnet wird, dass das zumindest eine Plattenelement (5) als Rahmen für das technische Modul (4) in dieser Funktionsebene wirkt, und dass das zumindest eine Plattenelement (5) und das zumindest eine technische Modul (4) zwischen den zwei Hauptglastafeln (2, 3) angeordnet werden.

## Claims

1. Glass composite with at least one first main glass panel (2), at least one second main glass panel (3) arranged at a distance therefrom and at least one plate element (5) arranged between the main glass panels (2, 3), with at least one technical module (4) arranged between the two main glass panels (2, 3) and wherein the plate element (5) delimits a recess (6) which is adapted to the shape of the technical module (4) and in which the technical module (4) is received, **characterized in that** lighting means (19) are integrated between two main glass panels (2, 3, 22, 33) and designed for the lateral feed of light between the main glass panels (2, 3, 22, 33) and that the lighting means (19) are thermally coupled with a spacer (9).

2. Glass composite according to claim 1, **characterized in that** the plate element (5) is designed in at least two parts and that the at least two parts adjoin edges of the technical module (4) in the plane between the main glass panels (2, 3).

3. Glass composite according to claim 1 or 2, **characterized in that** the technical module (4) is a display unit, an input unit, a sensor unit, a photovoltaic panel or a current and/or data-carrying and/or data-recording device, in particular a camera.

4. Glass composite according to any one of claims 1 to 3, **characterized in that** at least one of the main glass panels (2, 3) and the technical module (4) are arranged at a distance from one another with the aid of a spacer (9) in such a way that cooling of the technical module (4) is guaranteed.

5. Glass composite according to any one of claims 1 to 4, **characterized in that** adjacent to one of the main glass panels (2, 3), in particular that main glass panel (3) facing a rear side of the technical module (4), a lighting system is provided, which extends in a plane parallel to this main glass panel (2, 3) and comprises between this main glass panel (2, 3) and a third main glass panel (22) an embedded, light-guiding lighting panel (21).

6. Glass composite according to any one of claims 1 to 5, **characterized in that** a color layer is provided adjacent to one of the main glass panels (2, 3, 22), in particular that main glass panel (3, 22) facing a rear side of the technical module (4), the color layer running in a plane parallel to this main glass panel (2, 3, 22) and comprising a color panel (34) embedded between this main glass panel (2, 3, 22) and a further main glass panel (33).

7. Glass composite according to any one of claims 1 to 6, **characterized in that** conduit means (11) are provided which are provided for the electrically conductive connection of the electrical connections (12) of the technical module (4) to the surroundings of the glass composite (1),
- wherein the conduit means (11) in the plate element (5) have a bore or notch or groove (13) and comprise an electrical line (14) received there, and/or
- wherein the conduit means (11) comprise first conductor tracks (15) running on the edges of the plate element (5) and being linear or area-like there, and/or
- wherein spacers (9) are inserted between the main glass panels (2, 3) at the edge, which define the distance between the main glass panels (2, 3), the spacer (9) being part of the conduction means (11) and having electrically conductive structures in some areas, in particular in the form of cable-, line- or area-like, second conductor tracks (16) and/or
- wherein corner elements (17) between the spacers (9) form part of the conduit means (11) and have an electrically conductive leed-through (18) to electrically connect the technical module (4) to the surroundings of the glass composite (1).

8. Glass composite according to any one of claims 1 to 7, **characterized in that** the lighting means (19) have a light-emitting diode strip (24) comprising a board (32) with light-emitting diodes (23) attached and that the board (32) serves as a heat sink.

9. Glass composite according to any one of claims 1 to 8, **characterized in that** the at least one plate element (5) is arranged between the two main glass panels (2, 3) in a functional plane and acts as a frame in this functional plane for at least one technical module (4), by delimiting a recess (6) which is adapted to the shape of the technical module (4) and in which the technical module (4) is received.

10. Method for producing a glass composite (1) with at least one first main glass panel (2), at least one second main glass panel (3) arranged at a distance therefrom and at least one plate element (5) arranged between the main glass panels (2, 3), wherein at least one technical module (4) is arranged in a recess (6) of the at least one plate element (5) adapted to the shape of the technical module (4) and that the at least one plate element (5) and the at least one technical module (4) are arranged between the two main glass panels, **characterized in that** lighting means (19) are integrated between the main glass panels (2, 3, 22, 33), which are designed for the lateral feed of light between the main glass panels (2, 3, 22, 33), and that the lighting means (19) are thermally coupled to a spacer (9).

11. Method according to claim 10, **characterized in that** the plate element (5) is designed in at least two parts and the parts of the plate element (5) are aligned during arrangement in such a way that in the plane between the main glass panels (2, 3) edges of the technical module (4) adjoin the plate edges of the parts of the plate element (5).

12. Method according to claim 10 or 11, **characterized in that** spacers (9) are inserted between the main glass panels (2, 3) at the edge, so that at least one of the main glass panels (2, 3) and the technical module (4) are arranged at such a distance from one another using the spacers (9) such that cooling of the technical module (4) is guaranteed.

13. Method according to any one of claims 10 to 12, **characterized in that** adjacent to one of the main glass panels (2, 3), in particular that main glass panel (3) facing a rear side of the technical module (4), a lighting system is arranged, which in a plane parallel to this main glass panel (2, 3) and between this main glass panel (2, 3) and a third main glass panel (22) has an embedded, light-guiding lighting panel (21) and/or that adjacent to one of the main glass panels (2, 3, 22), in particular that main glass panel (3, 22) facing a rear side of the technical module (4), a color layer is arranged which runs in a plane parallel to this main glass panel (2, 3, 22) and has a color panel (34) that is embedded between this main glass panel (2, 3, 22) and a further main glass panel (33).

14. Method according to any one of claims 10 to 13, **characterized in that** at least one technical module (4) is arranged in a recess (6) adapted to the shape of the technical module (4) of at least one plate element (5) arranged in a functional plane in such a way that the at least one plate element (5) acts as a frame for the technical module (4) in this functional plane, and that the at least one plate element (5) and the at least one technical module (4) are arranged between the two main glass panels (2, 3).

## Revendications

1. Vitrage composite comprenant au moins une première plaque de verre principale (2), au moins une deuxième plaque de verre principale (3) espacée de la première, et au moins un panneau (5) disposé entre les plaques de verre principales (2, 3), dans lequel au moins un module technique (4) est disposé entre les deux plaques de verre principales (2, 3) et dans lequel le panneau (5) délimite un évidement (6) adapté à la forme du module technique (4) dans lequel le module technique (4) est logé, **caractérisé en ce que** des moyens d'éclairage (19) sont intégrés entre deux plaques de verre principales (2, 3, 22, 33) et sont conçus pour alimenter la lumière latéralement entre les plaques de verre principales (2, 3, 22, 33), et **en ce que** les moyens d'éclairage (19) sont couplés thermiquement à une cale d'espacement (9).

2. Vitrage composite selon la revendication 1, **caractérisé en ce que** le panneau (5) est formé en au moins deux parties et **en ce que** les au moins deux parties touchent aux bords du module technique (4) dans le plan entre les plaques de verre principales (2, 3).

3. Vitrage composite selon la revendication 1 ou 2, **caractérisé en ce que** le module technique (4) est une unité d'affichage, une unité d'entrée, une unité de capteur, un panneau photovoltaïque ou un dispositif de transport de courant et/ou de données et/ou d'enregistrement de données, en particulier une caméra.

4. Vitrage composite selon l'une des revendications 1 à 3, **caractérisé en ce qu'**au moins une des plaques de verre principales (2, 3) et le module technique (4) sont disposés à distance l'un de l'autre à l'aide d'une cale d'espacement (9) de telle façon qu'un refroidissement du module technique (4) est assuré.

5. Vitrage composite selon l'une des revendications 1 à 4, **caractérisé en ce qu'**il est prévu, adjacent à l'une des plaques de verre principales (2, 3), en particulier la plaque de verre principale (3) qui fait face à l'arrière du module technique (4), un système d'éclairage, qui s'étend dans un plan parallèle à ce plaque de verre principale (2, 3) et qui comprend une plaque d'éclairage intégré guidant la lumière (21) entre ce plaque de verre principale (2, 3) et un troisième plaque de verre principale (22).

6. Vitrage composite selon l'une des revendications 1 à 5, **caractérisé en ce qu'**il est prévu, adjacent à l'une des plaques de verre principales (2, 3, 22), en particulier la plaque de verre principale (3, 22) qui fait face à l'arrière du module technique (4), une couche de couleur, qui s'étend dans un plan parallèle à ce plaque de verre principale (2, 3, 22) et qui comprend une plaque de couleur (34) intégrée entre ce plaque de verre principale (2, 3, 22) et une autre plaque de verre principale (33).

7. Vitrage composite selon l'une des revendications 1 à 6, **caractérisé en ce que** des moyens conducteurs (11) sont prévus, qui sont agencés pour la connexion électriquement conductrice des connexions électriques (12) du module technique (4) à l'environnement du vitrage composite (1),
- dans lequel les moyens conducteurs (11) dans le panneau (5) sont pourvus d'un trou ou d'une encoche ou d'une rainure (13) et d'une ligne électrique (14) reçue dans celle-ci, et/ou
- dans lequel les moyens conducteurs (11) comportent de premiers chemins conducteurs (15) qui s'étendent aux bords du panneau (5) en forme de ligne ou de plan, et/ou
- dans lequel des cales d'espacement (9), qui définissent la distance des plaques de verre principales (2, 3) les uns aux autres, sont insérées par leurs bords entre les plaques de verre principales (2, 3), dans lequel la cale d'espacement (9) fait partie des moyens conducteurs (11) et comprend des structures électriquement conductrices dans certaines zones, en particulier sous forme de deuxièmes chemins conductrices (16) sous forme de câbles, de lignes ou de zones, et/ou dans lequel des éléments de coin (17) entre les cales d'espacement (9) font partie des moyens conducteurs (11) et comportent une traversée électriquement conductrice (18), pour la connexion électrique du module technique (4) à l'environnement du vitrage composite (1).

8. Vitrage composite selon l'une des revendications 1 à 7, **caractérisé en ce que** les moyens d'éclairage (19) comportent une bande de diodes électroluminescentes (24) comprenant une carte de circuit imprimé (32) avec des diodes électroluminescentes (23) attachées à celle-ci, et **en ce que** la carte de circuit imprimé (32) sert de dissipateur de chaleur.

9. Vitrage composite selon l'une des revendications 1 à 8, **caractérisé en ce que** l'au moins un panneau (5) entre les deux plaques de verre principales (2, 3) est agencé dans un plan fonctionnel et, dans ce plan fonctionnel, sert de cadre pour au moins un module technique (4), en délimitant un évidement (6) adapté à la forme du module technique (4) dans lequel le module technique (4) est logé.

10. Procédé de fabrication d'un vitrage composite (1) comprenant au moins une première plaque de verre principale (2), au moins une deuxième plaque de verre principale (3) espacée de la première, et au moins un panneau (5) disposé entre les plaques de verre principales (2, 3), dans lequel au moins un module technique (4) est agencé dans un évidement (6) adapté à la forme du module technique (4) de l'au moins un panneau (5), et en **ce que** l'au moins un panneau (5) et l'au moins un module technique (4) sont agencés entre les deux plaques de verre principales, **caractérisé en ce que** des moyens d'éclairage (19) sont intégrés entre les plaques de verre principales (2, 3, 22, 33), qui sont conçus pour alimenter la lumière latéralement entre les plaques de verre principales (2, 3, 22, 33), et **en ce que** les moyens d'éclairage (19) sont couplés thermiquement à une cale d'espacement (9).

11. Procédé selon la revendication 10, **caractérisé en ce que** le panneau (5) est formé en au moins deux parties, dans lequel les parties du panneau (5) sont alignées lors de l'installation de telle manière que des bords du module technique (4) touchent aux bords de panneau des parties du panneau (5) dans le plan entre les plaques de verre principales (2, 3).

12. Procédé selon la revendication 10 ou 11, **caractérisé en ce que** des cales d'espacement (9) sont insérées par leurs bords entre des plaques de verre principales (2, 3), de telle manière qu'au moins une des plaques de verre principales (2, 3) et le module technique (4) sont disposés à distance l'un de l'autre à l'aide des cales d'espacement (9) de telle façon qu'un refroidissement du module technique (4) est assuré.

13. Procédé selon l'une des revendications 10 à 12, **caractérisé en ce qu'**un système d'éclairage, qui s'étend dans un plan parallèle à ce plaque de verre principale (2, 3) et qui comprend une plaque d'éclairage intégré guidant la lumière (21) entre ce plaque de verre principale (2, 3) et un troisième plaque de verre principale (22), est agencé adjacent à l'une des plaques de verre principales (2, 3), en particulier la plaque de verre principale (3) qui fait face à l'arrière du module technique (4), et/ou **en ce qu'**une couche de couleur, qui s'étend dans un plan parallèle à ce plaque de verre principale (2, 3, 22) et qui comprend une plaque de couleur (34) intégrée entre ce plaque de verre principale (2, 3, 22) et une autre plaque de verre principale (33), est agencée adjacente à l'une des plaques de verre principales (2, 3, 22), en particulier la plaque de verre principale (3, 22) qui fait face à l'arrière du module technique (4).

14. Procédé selon l'une des revendications 10 à 13, **caractérisé en ce qu'**au moins un module technique (4) est agencé dans un évidement (6) adapté à la forme du module technique (4) d'au moins un panneau (5) agencé dans un plan fonctionnel, de telle manière que l'au moins un panneau (5) sert de cadre pour le module technique (4) dans ce plan fonctionnel, et **en ce que** l'au moins un panneau (5) et l'au moins un module technique (4) sont agencés entre les deux plaques de verre principales (2, 3).
